# EUROPEAN PATENT APPLICATION

(11) **EP 4 246 125 A1**
(43) Date of publication of application: **20.09.2023**
(21) Application number: 23162367.9
(22) Date of filing: 16.03.2023
(51) Int. Cl.: G01N 17/00, G01M 99/00, G01R 31/28

(54) **TEMPERATURE CHAMBER**

(30) Priority: 17.03.2022 JP 2022042847
(71) Applicant: Espec Corp., Kita-ku Osaka-shi Osaka 530-8550 (JP)
(72) Inventor: NISHIKAWA, Taihei, Osaka, 530-8550 (JP); KIKUCHI, Kaori, Osaka, 530-8550 (JP); TANAKA, Hirokazu, Osaka, 530-8550 (JP)
(74) Representative: Daub, Thomas

(57) **Abstract**

Temperature chamber (1) including: a heat transfer member (11) in which a bottom wall (20) and side walls ()21 are integrated; a recessed portion (5) surrounded by the bottom wall and the side walls; and a heat source member (11) that is configured to heat and/or cool the heat transfer member.

## Description

### Technical Field

The present invention relates to an apparatus in which a specimen can placed in a desired temperature environment.

### Background Art

Research on communication technology and computer control technology has been active in recent years, and for example, electronic devices used for Internet of Things (IoT) and autonomous driving have been developed on a daily basis.

These electronic devices may be used in various temperature environments. For this reason, it may be necessary to evaluate temperature characteristics of the electronic devices and components thereof such as semiconductors, electronic components, and materials, and to investigate influences of the temperature environments.

It may also be desired to know physical changes such as deformation or warping of substrates or the like when the substrates are exposed to a high-temperature environment or a low-temperature environment.

Patent Literature 1 discloses a heating and cooling test apparatus that can be used for this purpose.

In the heating and cooling test apparatus disclosed in Patent Literature 1, a plate on which a specimen is placed is attached to an upper surface of a Peltier module.

In the heating and cooling test apparatus disclosed in Patent Literature 1, the plate on which the specimen is placed is exposed, and the heating and cooling test apparatus does not include a member that covers the plate.

### Citation List

### Patent Literature

Patent Literature 1: JP2010-287729A

### Summary of Invention

### Technical Problem

In the heating and cooling test apparatus described in Patent Literature 1, the temperature of the plate is controlled by the Peltier module that is on a back surface of the plate. The specimen is placed on the plate and directly receives heat conduction from the plate.

In the heating and cooling test apparatus described in Patent Literature 1, a lower surface side of the specimen is in contact with the plate and is thus adjusted to a desired temperature. However, an upper surface side of the specimen is largely affected by the surrounding air temperature and may have a temperature different from that of the lower surface side.

The present invention pays attention to the above problem, and an object of the present invention is to provide a temperature chamber that can make the temperature of an entire specimen uniform.

### Solution to Problem

According to an aspect of the present invention, there is provided a temperature chamber including a heat transfer member in which a bottom wall and side walls are integrated, a recessed portion surrounded by the bottom wall and the side walls, and a heat source member that is configured to heat and/or cool the heat transfer member.

The temperature chamber of the present aspect includes the recessed portion, and a specimen is placed in the recessed portion.

In the temperature chamber of the present aspect, the recessed portion is formed of a heat transfer member in which the bottom wall and the side walls are integrated. The surface temperature of the heat transfer member is adjusted by receiving heat or cooling from the heat source member, the flow of heat between the bottom wall and the side walls is smooth since the heat transfer member has an integrated structure of the bottom wall and the side walls, so that the temperature of the bottom wall is substantially equal to that of the side walls.

Although the temperature of the specimen is also adjusted by radiant heat from the side walls, in the temperature chamber according to this aspect, the temperature on the upper surface side of the specimen is also close to the temperature on the lower surface side since the temperature of the bottom wall is substantially equal to that of the side walls.

Since the space in the recessed portion is surrounded by the bottom wall and the side walls, the air temperature in the space is close to the temperature of the inner walls of the recessed portion.

For this reason, in the specimen in the recessed portion, portions other than a placement surface (lower surface) of the specimen are also placed in an environment substantially the same as that of the placement surface, and the temperature of the entire specimen can be made uniform.

In the above aspect, it is preferable that at least one of the side walls has a non-uniform thickness.

In each of the above aspects, it is preferable that at least one of the side walls has a larger thickness in a bottom region than in any other region.

In the temperature chamber of this aspect, since the side wall has a relatively large thickness in the bottom region, the flow of heat between the bottom wall and the side wall is smooth, and the temperature of the bottom wall is substantially equal to that of the side wall.

In each of the above aspects, it is preferable that at least one of the side walls has a smaller planar cross-sectional area on an upper side than on a bottom side.

In the temperature chamber of this aspect, since the side wall has a relatively large planar cross-sectional area in the bottom region, the flow of heat between the bottom wall and the side walls is smooth, and the temperature of the bottom wall is substantially equal to that of the side wall.

In each of the above aspects, it is preferable that the recessed portion is provided with a step portion on an inner side surface.

According to this aspect, the specimen can be placed in the air by the step portion.

In each of the above aspects, it is preferable that the temperature chamber further includes a lid member, the recessed portion is configured to be sealed with the lid member, the lid member has a window, and inside of the recessed portion is configured to be observed from outside.

Since the temperature chamber of this aspect includes the lid member and the recessed portion can be sealed with the lid member, the inside of the recessed portion can be blocked from the outside, and an influence of outside air can be reduced.

In addition, since the window is provided, the inside of the recessed portion can be observed from the outside even when the recessed portion is sealed.

### Advantageous Effects of Invention

When the temperature chamber of the present invention is used, the temperature of the entire specimen can be made relatively uniform.

### Brief Description of Drawings

FIG. 1 is a perspective view of a temperature chamber according to an embodiment of the present invention.
FIG. 2 is a cross-sectional view taken along a line A-A of FIG. 1.
FIG. 3 is an exploded perspective view of the temperature chamber in FIG. 1.
FIG. 4A is a cross-sectional view of a heat transfer member taken along a line B-B in FIG. 3.
FIG. 4B is a cross-sectional view of the heat transfer member taken along a line C-C in FIG. 3.
FIG. 5A is a cross-sectional view of a body portion illustrating a state in which a specimen is placed in the temperature chamber in FIG. 1, and illustrates a state in which the specimen is placed on a bottom wall.
FIG. 5B is a cross-sectional view of the body portion illustrating a state in which the specimen is placed in the temperature chamber in FIG. 1, and illustrates a state in which the specimen is supported in the air by a step portion.
FIG. 6A is a cross-sectional view of the body portion illustrating a modification of the body portion.
FIG. 6B is a cross-sectional view of the body portion illustrating a modification of the body portion.
FIG. 6C is a cross-sectional view of the body portion illustrating a modification of the body portion.
FIG. 7A is a plan cross-sectional view of the body portion illustrating a modification of the heat transfer member.
FIG. 7B is a plan cross-sectional view of the body portion illustrating a modification of the heat transfer member.

### Description of Embodiments

Hereinafter, an embodiment of the present invention will be described.

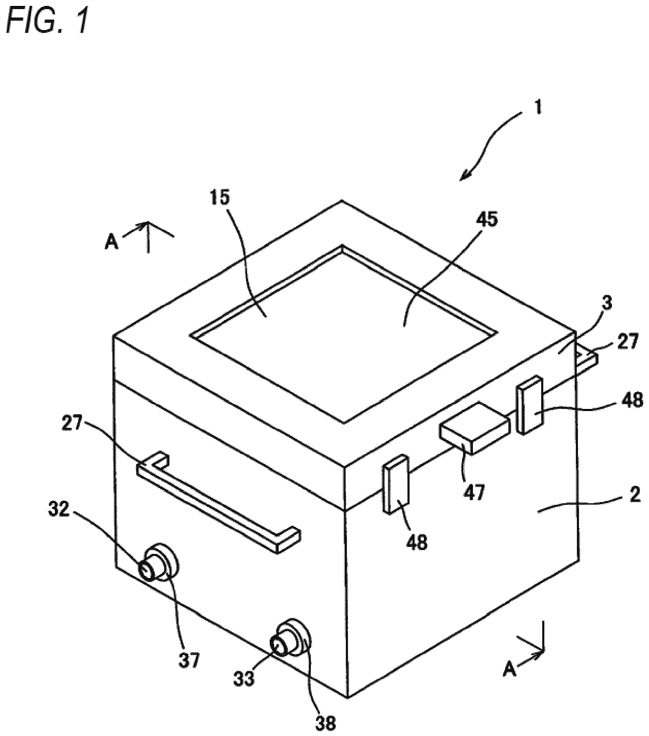

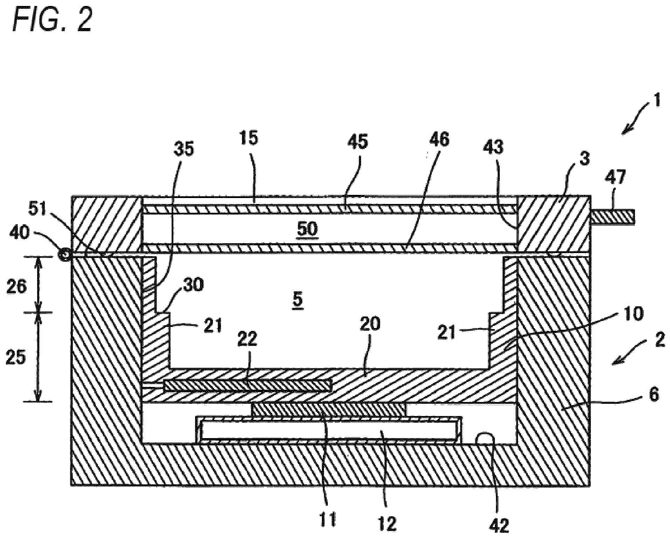

As illustrated in FIGS. 1 and 2, a temperature chamber 1 according to the present embodiment includes a body portion 2 and a lid member 3.

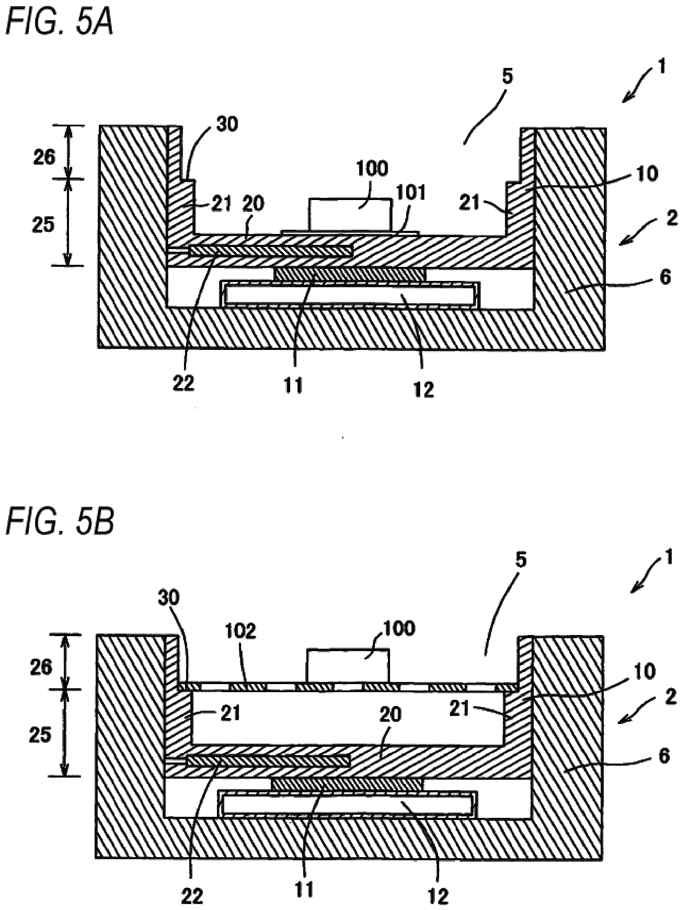

The body portion 2 includes a recessed portion 5 having an upper surface opened, and a specimen 100 (FIGS. 5A and 5B) is placed in the recessed portion 5. The body portion 2 is obtained by inserting a heat transfer member 10, a heat source member 11, and a heat sink 12 into a body box 6 made of a heat insulating material. In the present embodiment, the recessed portion 5 is provided in the heat transfer member 10.

The lid member 3 is attached to the body portion 2 and opens and closes the upper surface of the recessed portion 5. The lid member 3 is provided with a window 15.

Hereinafter, these members will be described.

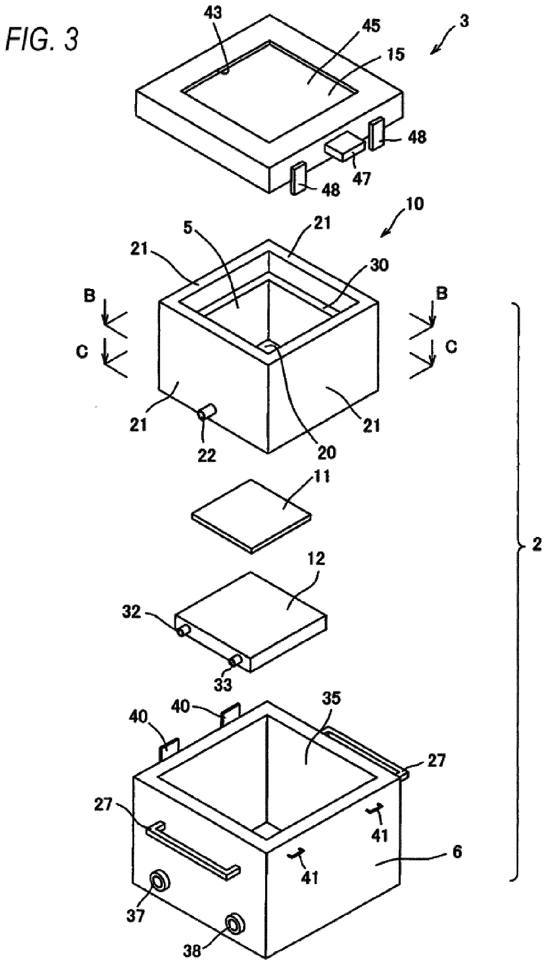

As illustrated in FIGS. 2 and 3, an outline of an outer shape of the heat transfer member 10 is a rectangular parallelepiped, and the recessed portion 5 having an upper surface opened is formed in the heat transfer member 10.

As illustrated in FIGS. 2 and 3, the heat transfer member 10 includes a bottom wall 20 and four side walls 21 surrounding the bottom wall 20, and the recessed portion 5 is surrounded by the bottom wall 20 and the four side walls 21.

In the heat transfer member 10 according to the present embodiment, the bottom wall 20 and the four side walls 21 are integrated.

A method for manufacturing the heat transfer member 10 is not limited, and in the present embodiment, the heat transfer member 10 is formed by cutting a metal block having excellent thermal conductivity, such as aluminum or a copper alloy.

That is, the metal block is cut to form an outer shape of a rectangular parallelepiped, and a rectangular parallelepiped hole serving as the recessed portion 5 is made in the rectangular parallelepiped member. For this reason, the heat transfer member 10 has a seamless integral structure.

As another method for manufacturing the heat transfer member 10, it is conceivable to separately mold the bottom wall 20 and the four side walls 21 and integrate the bottom wall 20 and the four side walls 21 by welding or the like.

It is also possible to form the heat transfer member 10 in which the bottom wall 20 and the four side walls 21 have an integrated structure by bending or forging.

In the heat transfer member 10 employed in the present embodiment, the side wall 21 has a non-uniform thickness, and as illustrated in FIG. 2, the thickness is different between a lower region 25 on a bottom side and an upper region 26 on an opening side. Specifically, the lower region 25 has a larger thickness than the upper region 26 of the heat transfer member 10. That is, the side wall 21 has a larger wall thickness in a bottom region than in any other region of the side wall 21.

A ratio of the thickness is not limited, and in the present embodiment, the thickness of the lower region 25 is equal to that of the bottom wall 20, and the upper region 26 is thinner than the bottom wall 20.

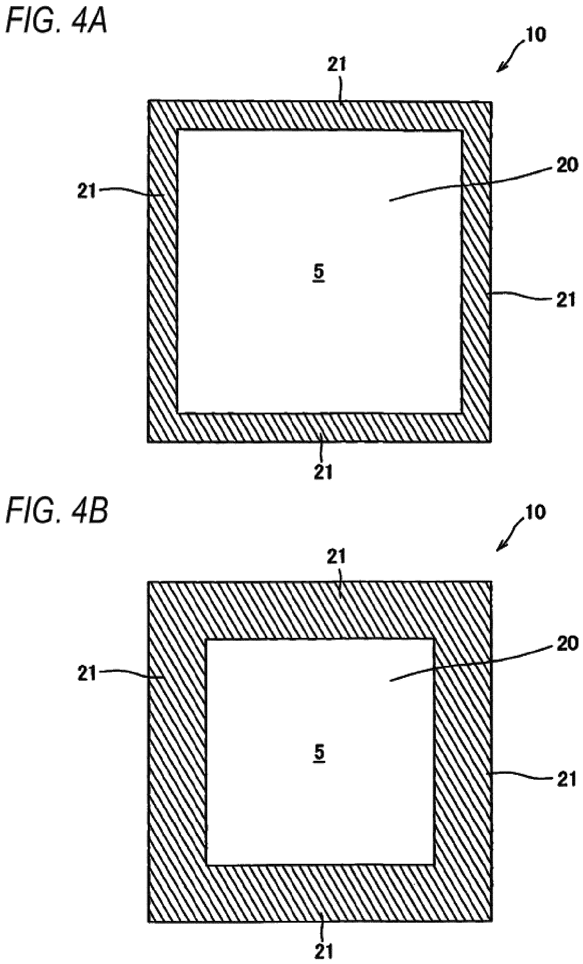

As illustrated in FIGS. 4A and 4B, the side wall 21 has a smaller planar cross-sectional area on an upper side (see FIG. 4A) than on a bottom side (see FIG. 4B).

In the present embodiment, the lower region 25 of the side wall 21 has a uniformly large wall thickness. The upper region 26 of the side wall 21 has a uniformly small wall thickness.

For this reason, an inner surface at a boundary portion between the lower region 25 and the upper region 26 constitutes a step portion 30.

In the heat transfer member 10 according to the present embodiment, the upper region 26 of the side wall 21 is shaved more than the lower region 25, so that an inner surface of the heat transfer member 10 that is in contact with air in the recessed portion 5 has a large area. That is, in the heat transfer member 10 according to the present embodiment, an inner surface of the side wall 21 has a larger area than that in a structure having a uniformly large thickness at the side wall.

In the present embodiment, a temperature sensor 22 is attached to the bottom wall 20 of the heat transfer member 10. The temperature sensor 22 includes a temperature detector (not illustrated) located near the center of the bottom wall 20.

The heat source member 11 is a Peltier member including a Peltier element therein.

The Peltier member includes the Peltier element sandwiched between two metal plates, and when the Peltier element is energized, one of the metal plates generates heat to raise the temperature, and the other metal plate absorbs heat to lower the temperature.

The heat sink 12 is a tank storing a coolant such as water, and includes a water inlet pipe 32 and a water outlet pipe 33 as illustrated in FIG. 3.

The body box 6 is a box body made of a heat insulating material, and constitutes an outline of the body portion 2.

The body box 6 has a substantially rectangular parallelepiped shape and includes a recessed portion 35 in a central portion. The body box 6 has, in one side surface thereof, openings 37 and 38 through which the water inlet pipe 32 and the water outlet pipe 33 of the heat sink 12 are inserted.

The body box 6 includes hinges 40 on one side of an upper portion and engagement portions 41 on the other side of the upper portion.

The body box 6 includes a handle 27 on each of opposite wall surfaces thereof.

As illustrated in FIGS. 2 and 3, in the body portion 2, the heat transfer member 10 is disposed in the recessed portion 35 of the body box 6, and the heat sink 12 and the heat source member 11 are disposed between an inner bottom 42 of the body box 6 and the bottom wall 20 of the heat transfer member 10.

In the present embodiment, one surface of the heat source member 11 is in direct contact with a bottom surface of the heat transfer member 10, and the other surface of the heat source member 11 is in direct contact with the heat sink 12.

The lid member 3 is a plate-shaped member having a lower surface coinciding with the upper surface of the body portion 2.

The lid member 3 is provided with a window 15. The window 15 is obtained by fitting glass plates 45 and 46 into a quadrangular opening 43 that is provided in the center of the lid member 3 and penetrates the inside and the outside thereof.

The glass plates 45 and 46 are both made of quartz glass having heat resistance and high optical transparency.

A gap 50 is defined between the glass plates 45 and 46, and dry air is supplied into the gap 50 from a supply port (not illustrated). By supplying dry air to the gap 50 between the glass plates 45 and 46, the glass plates 45 and 46 can be suppressed from fogging and having condensation.

The lid member 3 is provided with a handle 47 on one side thereof. The lid member 3 is provided with two sets of toggle mechanism closure tools 48 on the same side.

As illustrated in FIG. 2, the lid member 3 is provided with packings 51 on a lower surface thereof.

The lid member 3 is attached to the body portion 2 via the hinges 40, so that the recessed portion 5 of the body portion 2 can be opened and closed.

The recessed portion 5 of the body portion 2 can be opened when the lid member 3 is opened, and the recessed portion 5 can be sealed when the lid member 3 is closed. In the present embodiment, since the lid member 3 is provided with the packings 51, the inside of the recessed portion 5 is brought into a sealed state by closing the lid member 3.

When the lid member 3 is closed, the closure tools 48 are engaged with the engagement portions 41 of the body portion 2, and the closure tools 48 are set in the posture illustrated in FIG. 1. As a result, the lid member 3 is pulled and tightened to the body portion 2 by the toggle mechanisms.

Next, a method for using the temperature chamber 1 according to the present embodiment and operations thereof will be described.

The temperature chamber 1 according to the present embodiment can perform an environmental test on the specimen 100 such as an electronic component or a substrate.

As a first step, the specimen 100 is placed in the recessed portion 5. For example, as illustrated in FIG. 5A, the specimen 100 is placed on the bottom wall 20 of the recessed portion 5. As illustrated in FIG. 5A, the specimen 100 may be placed on the bottom wall 20 through a sheet 101 or a paste having excellent thermal conductivity, or be directly placed on the bottom wall 20.

Then, the lid member 3 is closed to seal the recessed portion 5, and the heat source member 11 is energized.

The detected temperature of the temperature sensor 22 is monitored by a control device (not illustrated), and the energization amount of the heat source member 11 is controlled by P.I.D such that the detected temperature of the temperature sensor 22 becomes a desired temperature.

The heat source member 11 is a Peltier member, and can heat or cool the heat transfer member 10. For example, the heat source member 11 is energized such that a surface thereof on the heat transfer member 10 side is in a low-temperature state. In this case, cooling water flows through the heat sink 12.

When the heat source member 11 is energized and the surface thereof on the heat transfer member 10 side is brought into the low-temperature state, the temperature of a surface on the opposite side increases, but heat is taken by the heat sink 12 and discharged to the outside.

When the heat source member 11 is energized, heat is transferred from the heat transfer member 10 to the heat source member 11. Although heat moves from a high-temperature side to a low-temperature side, for convenience of description, it is expressed that cold heat moves from the heat source member 11 to the heat transfer member 10.

According to this expression, when the heat source member 11 is energized, the temperature of one surface of the heat source member 11 decreases, and the cold heat moves from the heat source member 11 to the heat transfer member 10.

The cold heat moves to the bottom wall 20 of the heat transfer member 10 with which the heat source member 11 is in contact, and spreads from the bottom wall 20 to the side wall 21.

Here, the heat transfer member 10 employed in the present embodiment has a structure in which the bottom wall 20 and four side walls 21 are integrated with no seam, and thus the flow of heat between the bottom wall 20 and the four side walls 21 is smooth.

In addition, in the heat transfer member 10 employed in the present embodiment, a connecting portion between the side wall 21 and the bottom wall 20 has a large thickness, and a movement surface through which the cold heat passes is large.

For this reason, the thermal resistance between the bottom wall 20 and the four side walls 21 is small, the flow of heat between the bottom wall 20 and the four side walls 21 is smoother, and the temperature of the side walls 21 is close to the temperature of the bottom wall 20.

The specimen 100 is substantially in contact with the bottom wall 20 of the heat transfer member 10, and a lower surface of the specimen 100 substantially directly receives cold heat from the bottom wall 20.

On the other hand, since the temperature of the side wall 21 is close to the temperature of the bottom wall 20, an upper surface and side surfaces of the specimen 100 are cooled by the radiant heat. Further, since the temperature of the side wall 21 is close to the temperature of the bottom wall 20, the spatial temperature in the recessed portion 5 is close to the temperature of the bottom wall 20, and the upper surface and the side surfaces of the specimen 100 are cooled.

As a result, the temperature of the upper surface is close to that of the lower surface of the specimen 100.

In the embodiment described above, the specimen 100 is placed on the bottom wall 20 of the recessed portion 5. Alternatively, as illustrated in FIG. 5B, the specimen 100 may be placed in a position in the air by the step portion 30.

In the embodiment illustrated in FIG. 5B, a net-shaped holding plate 102 is placed on the step portion 30, the holding plate 102 is held in a position apart from the bottom wall 20 in the height direction, and the specimen 100 is placed on the holding plate 102. As a result, the specimen 100 is held in a position in the air in the recessed portion 5.

The heat transfer member 10 described above has a structure in which the lower region 25 has a different wall thickness from the upper region 26 with the step portion 30 as a boundary, and has a two-stage structure having different thicknesses between the lower region 25 and the upper region 26. Alternatively, the heat transfer member 10 may have different wall thicknesses in three or more stages.

In the heat transfer member 10 described above, the lower region 25 of the side wall 21 has the same and uniformly large wall thickness in any position, and the upper region 26 of the side wall 21 has the same and uniformly small wall thickness in any position.

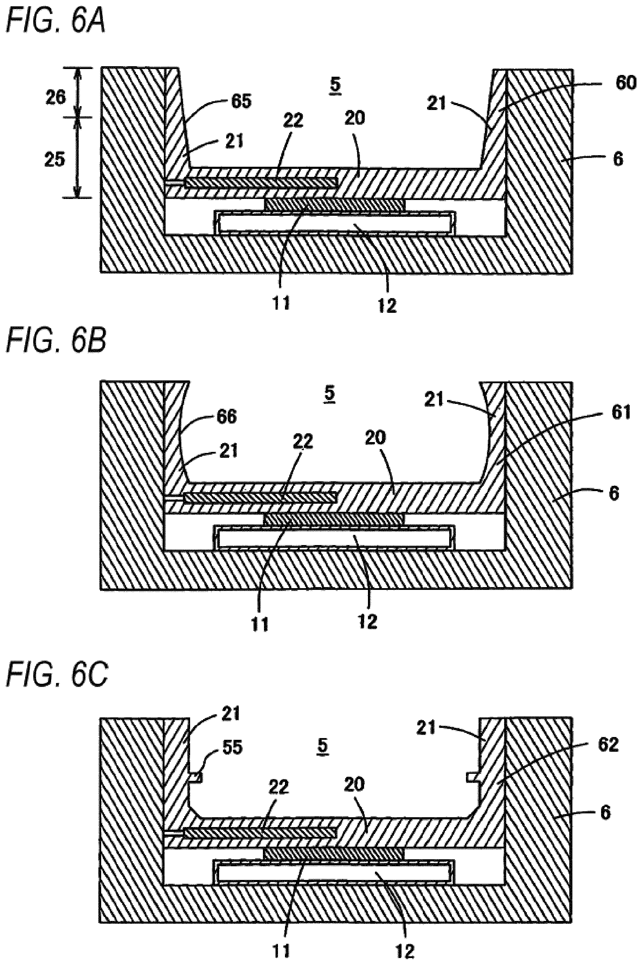

The present invention is not limited to this cross-sectional shape. For example, as in a heat transfer member 60 illustrated in FIG. 6A, an inner wall surface may have a cross-sectional shape of an inclined surface 65.

In the heat transfer member 60 according to the present embodiment, the side wall 21 also has a non-uniform thickness, and the lower region 25 has a larger thickness than the upper region 26. That is, the side wall 21 has a larger wall thickness in a bottom region than in any other region of the side wall 21. The side wall 21 has a smaller planar cross-sectional area on an upper side than on a bottom side.

In addition, for example, as illustrated in FIG. 6B, a heat transfer member 61 may have an inner wall surface having a cross-sectional shape of a curved surface 66. The side wall 21 has a smallest thickness in a middle region between an upper region and a lower region. The lower region of the side wall 21 has a larger wall thickness than the middle region.

In the heat transfer member 61 according to the present embodiment, the side wall 21 also has a non-uniform thickness, and the lower region has a larger thickness than the middle region having the smallest wall thickness. That is, the side wall 21 has a larger wall thickness in the bottom region than in any other region. The side wall 21 has a smaller planar cross-sectional area in the middle height than on the bottom side.

Further, as in a heat transfer member 62 illustrated in FIG. 6C, a protrusion 55 may be provided on the inner wall surface. In the heat transfer member 62 illustrated in FIG. 6C, the protrusion 55 constitutes a step portion on the inner side surface.

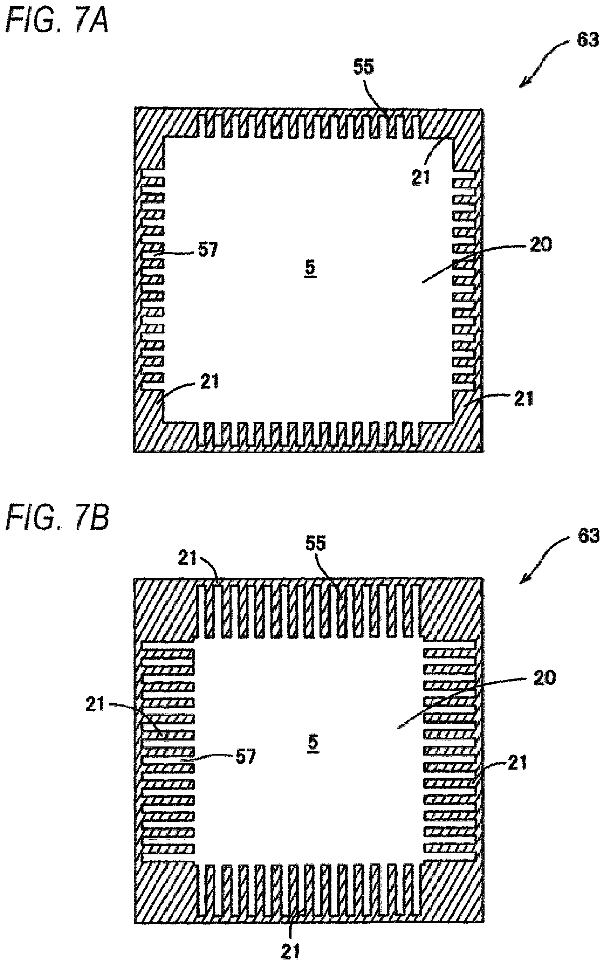

As in a heat transfer member 63 illustrated in FIGS. 7A and 7B, vertical grooves 57 may be provided in the side wall 21. In the heat transfer member 63 according to the present embodiment, the side wall 21 has a fin shape and has a large contact area with air, and the spatial temperature in the recessed portion 5 is easily brought close to the temperature of an inner wall of the heat transfer member 63.

In the embodiment described above, the four side walls 21 have the same cross-sectional shape, but may also have a different cross-sectional shape mixed therein.

For example, one of the side walls may have a linear vertical surface on an inner surface. That is, one of the side walls may have a uniform thickness. In addition, all the side walls may have a uniform thickness.

In the embodiment described above, the temperature sensor 22 is attached to the bottom wall 20 of the heat transfer member 10. Alternatively, the attachment position of the temperature sensor 22 may be freely selected, and the temperature sensor 22 may be attached to the side wall 21.

The temperature sensor 22 may be attached to the specimen 100 to control the temperature of the specimen 100 to a desired temperature. As another example, the temperature sensor 22 may be installed in the recessed portion 5 to control the internal spatial temperature to a desired temperature.

In the embodiment described above, the lid member 3 is provided with the window 15 so that the inside of the temperature chamber 1 can be visually observed, but the presence or absence of the window 15 is freely selected.

The use of the temperature chamber 1 is not limited.

Even when the temperature chamber 1 is used for the environmental test, the test method may be freely selected, and for example, a change in the specimen 100 may be examined while the temperature of the recessed portion 5 is kept constant. As in a thermal cycle test, the temperature of the recessed portion 5 may be repeatedly changed between a high-temperature environment and a low-temperature environment to examine the change in the specimen 100.

In the embodiment described above, the Peltier member is used as the heat source member 11. Alternatively, a refrigeration apparatus or an electric heater may be used instead of the Peltier member.

Since the refrigeration apparatus is accompanied by vibration, it is recommended to employ the Peltier member having no vibration.

The temperature chamber 1 according to the present embodiment can increase the speed of a temperature change in the heat transfer member 10 and the like and the speed of a temperature change in the internal air. In the temperature chamber 1 according to the present embodiment, uniformization of the surface temperature of the heat transfer member 10 is promoted, and the temperature of the internal air is relatively uniform.

Further, in the temperature chamber 1, since the side wall 21 of the heat transfer member 10 and the like has a small thickness on the upper side, the heat transfer member 10 and the like has a relatively small heat capacity. For this reason, the temperature change in the heat transfer member 10 is relatively fast.

In addition, in the heat transfer member 10 and the like described above, the inner surface that is in contact with air in the recessed portion 5 has a larger area on the upper side than on the bottom side. For this reason, the transfer of heat from the side wall 21 to air in the recessed portion 5 is promoted, and the temperature change in air in the recessed portion 5 is relatively fast.

Further, in the heat transfer member 10 and the like employed in the temperature chamber 1 described above, since the lower portion of the side wall 21 has a large thickness to ensure the cross-sectional area of a connecting region between the bottom wall 20 and the side wall 21, the thermal resistance between the bottom wall 20 and the side wall 21 is small, and the transfer of heat from the bottom wall 20 to the side wall 21 is not hindered. For this reason, the temperature change in the heat transfer member 10 and the like and the temperature change in air in the recessed portion 5 are relatively fast.

In addition, according to the embodiment described above, the temperature of the heat transfer member 10 is uniform, and thus the temperature of a part of the heat transfer member 10 can be suppressed from becoming excessively high or excessively low, and the thickness of the heat insulating material can be reduced. For this reason, an outer shape of the entire apparatus can be reduced.

According to the structure including the step portion 30 or the protrusion 55, the specimen 100 can be held at a height in the air by the step portion 30 and the like. In addition, a shelf on which the specimen 100 is placed may be provided by the step portion 30 and the like.

Since the temperature chamber 1 described above has a large opening, a larger specimen 100 can be placed.

### Reference Signs List

- 1: temperature chamber
- 2: body portion
- 3: lid member
- 5: recessed portion
- 6: body box
- 10, 60, 61, 62, 63: heat transfer member
- 11: heat source member
- 12: heat sink
- 15: window
- 20: bottom wall
- 21: side wall
- 25: lower region
- 26: upper region
- 30: step portion
- 100: specimen

## Claims

1. A temperature chamber (1) **characterized by** comprising:
a heat transfer member (10, 60, 61, 62, 63) in which a bottom wall (20) and side walls (21) are integrated;
a recessed portion (5) surrounded by the bottom wall (20) and the side walls (21); and
a heat source member (11) that is configured to heat and/or cool the heat transfer member (10, 60, 61, 62, 63).

2. The temperature chamber (1) according to claim 1, wherein at least one of the side walls (21) has a non-uniform thickness.

3. The temperature chamber (1) according to claim 1 or 2, wherein at least one of the side walls (21) has a larger thickness in a bottom region than in any other region.

4. The temperature chamber (1) according to any one of claims 1 to 3, wherein at least one of the side walls (21) has a smaller planar cross-sectional area on an upper side than on a bottom side.

5. The temperature chamber (1) according to any one of claims 1 to 4, wherein the recessed portion (5) is provided with a step portion (30) on an inner side surface.

6. The temperature chamber (1) according to any one of claims 1 to 5, further comprising: a lid member (3),
wherein the recessed portion (5) is configured to be sealed with the lid member (3), the lid member (3) has a window (15), and inside of the recessed portion (5) is configured to be observed from outside.
